# EUROPEAN PATENT SPECIFICATION

(11) **EP 2 793 541 B1**
(45) Date of publication and mention of the grant of the patent: **30.12.2015**
(21) Application number: 14162122.7
(22) Date of filing: 27.03.2014
(51) Int. Cl.: H05K 13/04, B65G 33/04

(54) **Feeding device of electronic components arranged on a tape rolled up to form a reel**
Vorrichtung zum Zuführen von elektronischen Bauelementen auf einem Band aufgerollt zur Bildung einer Spule
Dispositif d'alimentation de composants électroniques disposés sur une bande enroulée pour former une bobine

(30) Priority: 19.04.2013 IT PR20130036
(43) Date of publication of application: 22.10.2014
(73) Proprietor: A.E.B. S.p.A., 42025 Cavriago (RE) (IT)
(72) Inventor: Zambonini, Sergio, 42027 MONTECCHIO EMILIA (RE) (IT)
(74) Representative: Gotra, Stefano

(56) References cited:
- EP-A2- 0 200 689
- DE-A1- 3 805 781
- FR-A1- 2 461 665
- GB-A- 966 328

## Description

The present invention relates to a feeding device of electronic components arranged on a tape rolled up to form a reel.

In particular, the feeding device proposed can be applied in apparatuses for the assembly on printed circuit boards of THT (through hole technology) electronic components, meaning components whose reophores are inserted into through holes in the printed circuit board, and SMT (surface mount technology) electronic components.

As is known, discrete electronic components are available loose or in reels.

The latter are fixed onto a tape made of paper or plastic, which is perforated at regular intervals according to its longitudinal development and is rolled up to form a reel. There is a succession of components one after the other at a predefined pitch (typically expressed in inches) following the longitudinal extension of the tape.

Up to now, devices are known adapted to feed electronic components in a reel to automatic or servo-assisted apparatuses for the assembly of the components onto a printed circuit board. Such automatic apparatuses are known in the field by the term "pick and place".

According to the prior art, the feeder comprises a reel unrolling and advancing system comprising one or more wheels which are provided with metal pins projecting from the circumferential profile so as to intercept, during the rotation, the holes in the tape in order to cause the unrolling and advancement. The control system is partly mechanical and partly electronic. The advancement of the tape implies the progressive advancement of the electronic components. At a predefined position along the advancement path, each component is separated from the others. For example, while the component to be separated is held by a gripper or a sucker, the tape is cut.

The document EP0200689 describes a traditional feeding device of electronic components arranged on a tape rolled up to form a reel.

The main drawback of the solution just described lies in the poor localisation precision of the component. In fact, the reel unrolling system is calibrated according to the spacing of the holes in the tape and not the effective position of the components on the tape itself.

Furthermore, the waiting times of the pick and place machine placed downstream of the feeder may be significant (e.g. in the order of seconds) both due to the picking delay of each component and the physical cut of the electrodes (or pins) of the component, which take place when the machine is stopped.

The solution just described implies a substantial percentage of picking waste and machine downtime.

Another decisive factor is the constant increase in the effective duration of the pick and place machine cycle during the assembly steps. This machine may have a pitch of up to 3000 mm/s and an acceleration of up to 5000 mm/s². With a cycle lasting 2.5 s, there will always be a waiting time (for cutting and communicating with the feeder) of at least 0.25-0.35 s. Another drawback is connected with the mechanical tension exerted by the picking means on the component while the tape is cut.

The use of metal guides adapted to limit the irregular presentation of the components to the pick and place machine represents an insufficient improvement. In fact, in this context the movement and cutting tolerances dictated by the delicate nature of the electrodes of the components themselves play an important role, often being electrically and not mechanically sized.

Feeding devices for feeding loose devices are disclosed by the documents FR2461665 and GB966328. According to these documents screw conveyors are used for feeding the loose electronic devices.

In this context, the technical task underpinning the present invention is to offer a feeding device of electronic components arranged on a tape rolled up to form a reel, which obviates the above-described drawbacks of the prior art.

In particular, an object of the present invention is to offer a feeding device of electronic components arranged on a tape rolled up to form a reel, which enables the precision of defining the position of the individual components to be improved.

A further object of the present invention is to provide a feeding device of electronic components arranged on a tape rolled up to form a reel, which enables the waiting times of the printed circuit board assembly apparatuses placed downstream to be reduced.

A further object of the present invention is to present a feeding device of electronic components arranged on a tape rolled up to form a reel, in which the mechanical stress on the individual components in the step of separating them from the others is eliminated or reduced.

Another object of the present invention is to provide a feeding device of electronic components arranged on a tape rolled up to form a reel, which is structurally simple and compact.

Another object of the present invention is to provide a feeding device of electronic components arranged on a tape rolled up to form a reel, which increases the probability of inserting the electrodes into the holes in the printed circuit board.

The specified technical objective and the set aims are substantially attained by a feeding device of electronic components arranged on a tape rolled up to form a reel, comprising the technical characteristics set down in one or more of the appended claims.

Further characteristics and advantages of the present invention will more fully emerge from the non-limiting description of a preferred but not exclusive embodiment of a feeding device of electronic components arranged on a tape rolled up to form a reel, as illustrated in the accompanying drawings, in which:

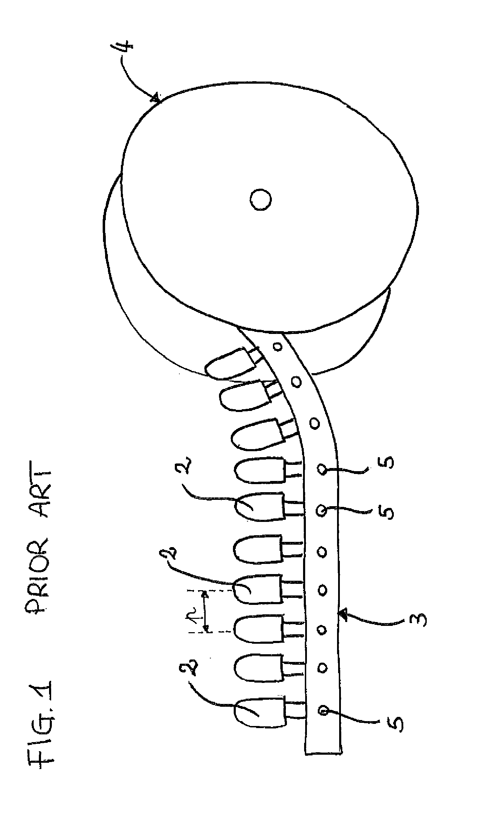

- Figure 1 illustrates a tape with electronic components, according to the prior art;
- Figure 1 illustrates a perspective view of a feeding device of electronic components arranged on a tape rolled up to form a reel, according to the present invention;

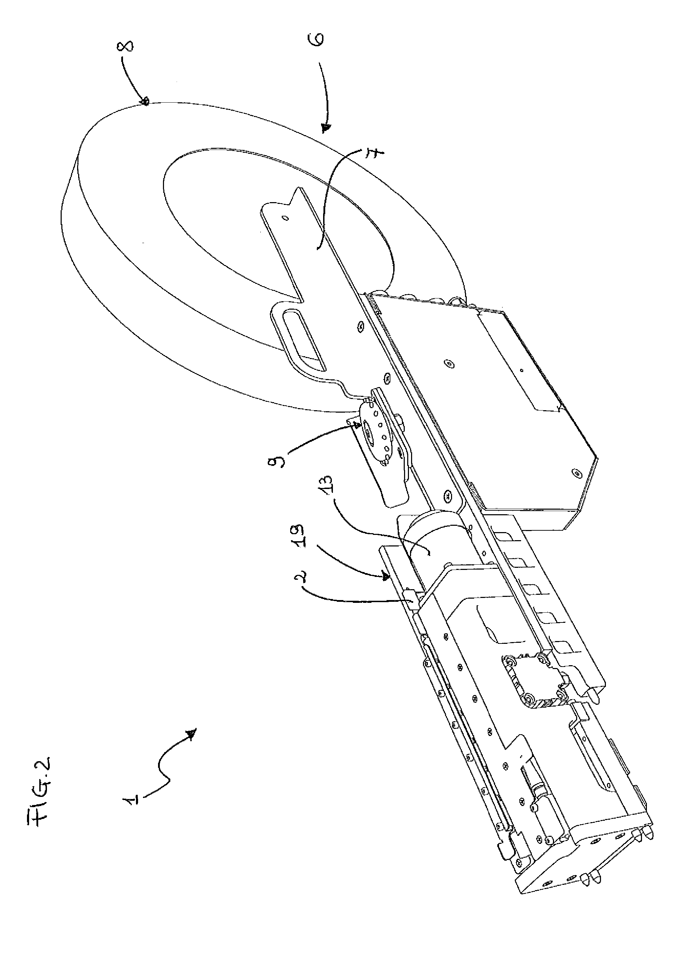

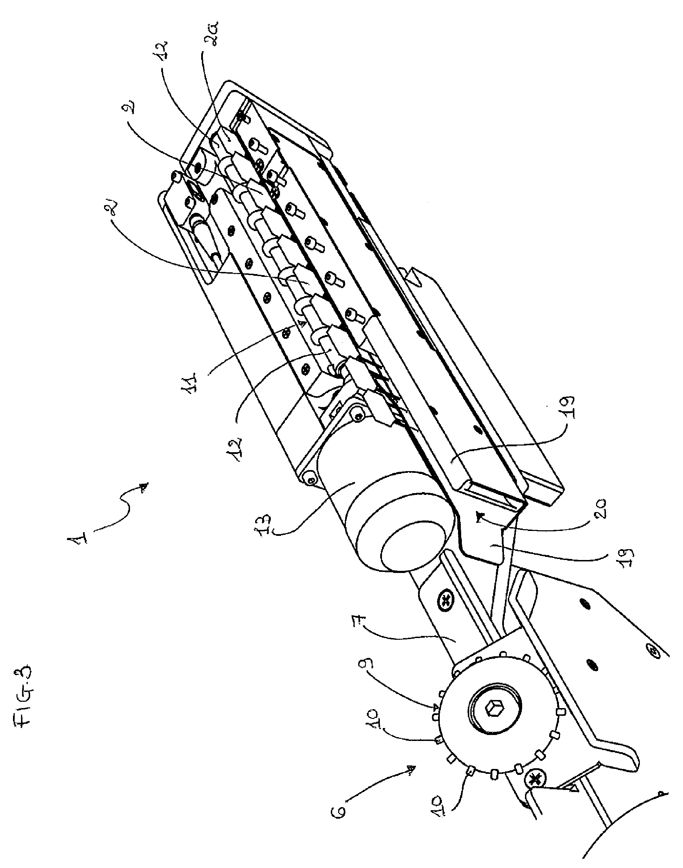

- Figure 3 partially illustrates the feeding device of figure 2 in a different perspective view;

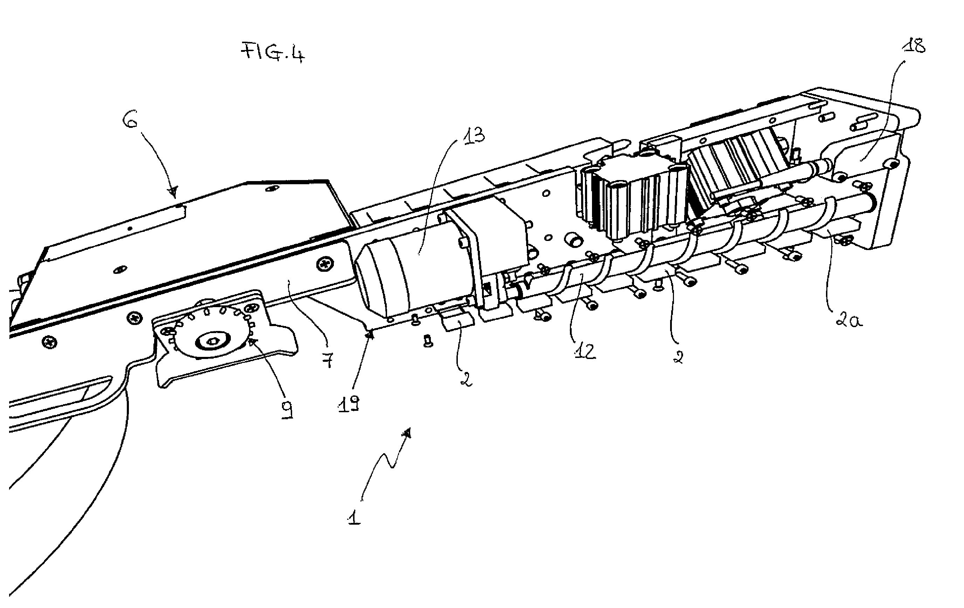

- Figure 4 partially illustrates the feeding device of figure 2 according to a further perspective view.

With reference to the figures, number 1 indicates a feeding device of electronic components 2 arranged on a tape 3 rolled up to form a reel 4.

For example, the tape 3 is made of paper or plastic or metal. The tape 3 has a plurality of holes 5 made at regular intervals according to its longitudinal extension. The electronic components 2 are arranged on the tape 3 at a predefined pitch p. The electronic components 2 may be passive (e.g. resistors, condensers, etc.) or active (e.g. diodes, transistors, etc.). The electronic components 2 may relate to THT or SMT. Electronic component 2, in this context, also means thin plates or contacts arranged on metal tape 3.

The feeding device 1 comprises means for supporting and unrolling 6 the reel 4. Preferably, the supporting and unrolling means 6 comprise a shaped plate 7 with a supporting element 8 for the reel 4 and a wheel 9 having projecting pins 10 designed to intercept the holes 5 in the tape 3. In the embodiment described and illustrated herein, the wheel 9 is idle.

The feeding device 1 further comprises means for advancing 11 the tape 3 rolled along a predefined path.

Originally, the advancing means 11 of the unrolled tape 3 comprise a screw conveyor 12 (i.e. a worm screw) shaped so as to engage the electronic components 2. In particular, the screw conveyor 12 is designed based on the planar projection of the profile of the electronic components 2.

In particular, the screw conveyor 12 is shaped according to the type of electronic components 2 fed, e.g. THT or SMT.

In the event of large or heavy electronic components 2, corresponding motorisation means (not shown) are associated with the wheel 9 in order to reduce the driving strain on the screw conveyor 12.

Preferably the screw conveyor 12 is made of anti-friction plastic or stainless steel with a surface finish designed to reduce its roughness.

The advancing means 11 of the tape 3 further comprise a motor 13 operatively active on the screw conveyor 12 to make it rotate. Preferably, the motor 13 is a stepper motor which for each complete rotation of the screw conveyor 12 envisages each electronic component 2 advancing by a length which is equivalent to the predefined pitch p of the components 2 on the tape 3.

The feeding device 1 comprises means for separating a front electronic component 2a from the remaining electronic components 2.

In particular, the means for separating the front electronic component 2a comprise first means for cutting the unrolled tape 3 and second means for cutting the electrodes (or pins) of the front electronic component 2a. Since both the first and the second cutting means are of the known type and do not constitute the core of the invention they are not described further or shown.

The first cutting means are arranged at a first cutting station along the predefined advancement path of the unrolled tape 3.

The second means for cutting the electrodes of the front electronic component 2a are arranged in a second cutting station along the predefined advancement path of the tape 3. Advantageously the second cutting station is placed in sequence after the first cutting station. Advantageously, the second cutting means are arranged so as to cut the electrodes with an angle that is lower than 45° so that the cut electrodes of the front component 2a have a substantially elliptical section.

The feeding device 1 comprises a control logic (not shown) for controlling the advancing means 11. In the embodiment described herein, the control logic comprises an electronic board dedicated to the advancing means and a sensor communicating with the dedicated electronic board and operatively active at the second cutting station to sense the arrival of the front component 2a.

To further increase the precision, it is possible to provide grippers for picking up the front component 2a (not shown).

The feeding device 1 comprises one or more guiding elements 19 arranged along the advancement path of the tape 3 and operatively active on the electronic components 2 to limit their deviation. In fact, during the rotation of the screw conveyor 12, the electronic components 2 may be subject to deviations or misalignments due to the friction during the engagement with the screw conveyor 12 blades, which are actually limited by the guiding elements 19.

The guiding elements 19 cooperate with the screw conveyor 12 to cause the precise advancement of the electronic components 2. In the embodiment described and illustrated herein, the guiding elements 19 define a passage channel 20 of the unrolled tape 3 alongside the screw conveyor 12.

To further reduce the deviations of the electronic components 2, it is possible to provide mechanical centring micro-cylinders (not shown).

To provide a purely indicative example of numerical sizing, the pitch diameter of the screw conveyor 12 is preferably always less than about 40 mm, the width of the feeding device 1 is about 88 mm and the total height is about 90 mm.

Below is a description of the operation of the feeding device of electronic components arranged on a tape rolled up to form a reel.

Consider a reel 4 placed on the supporting element 8. The rotation of the wheel 9, whose pins 10 intercept the holes 5 in the tape 3, causes the progressive unrolling of the tape 3, keeping it taut at the same time so as to prevent jamming. The tape 3 passes through the passage channel 20 defined by the guiding elements 19 and the electronic components 2 start to engage with the screw conveyor 12, which is placed in rotation by the stepper motor 13.

In particular, each electronic component 2 advances along the passage channel 20 by a length which is equivalent to the predefined pitch p of the components 2 on the tape 3.

At the first cutting station, the tape 3 is cut by the first cutting means.

The advancement of the screw conveyor 12 causes the arrival of the front component 2a in the second cutting area where the electrodes are sliced at an angle that is lower than 45° so as to show a substantially elliptical section.

The piece of tape (cut) that had the front component 2a is evacuated by using compressed air.

The sensor 18 senses the arrival of the front component 2a in the second cutting station, so as to be promptly picked up by the pick and place apparatus positioned downstream.

From the description given, the characteristics of the feeding device of electronic components arranged on a tape rolled up to form a reel are clear, as are the advantages.

In particular, the use of a screw conveyor shaped so as to engage the electronic components allows the precision of defining the position of the individual components to be improved. Compared to solutions of the prior art, in fact, the determination of the position no longer refers to the tape but to the components themselves.

Furthermore, thanks to the increased precision, it is possible to cut the tape and electrodes earlier, hence reducing the waiting times of the pick and place apparatus positioned downstream.

Furthermore, cutting the tape earlier prevents having to convey the waste tape into dedicated areas where it could get tangled and jam the mechanism.

Furthermore, the precision reached allows manufacturing faults, such as pitch deviations, position, height and orientation of electronic components, to be tolerated. In particular, it is possible to sacrifice the centesimal precision required by solutions of the prior art since the feeding device proposed can tolerate deviations in the region of 1-2 mm.

Furthermore, the feeding device proposed has a compact and simple design since it is based on a screw conveyor shaped according to the type of electronic components to be treated.

The compact nature of the device proposed allows the provision of a plurality of feeding devices pertaining to the same pick and place assembly apparatus in order to avoid replacements due to changing the type of components.

Furthermore, since the angle of attack for cutting the electrodes is lower than 45°, the cut electrodes have a substantially elliptical section, which allows higher coupling interference within the holes in the electronic board for the same insertion depth with respect to the diameter of the hole.

## Claims

1. A feeding device (1) of electronic components (2) arranged on a tape (3) rolled up to form a reel (4), comprising:
means for supporting and unrolling (6) the reel (4);
means for advancing (11) the unrolled tape (3) along a predefined path;
a control logic for the advancing means (11) comprising an electronic board dedicated to the electronic control of said advancing means (11);
means for separating a front electronic component (2a) from the remaining electronic components (2),
**characterised in that** said means for advancing (11) the tape (3) comprise a screw conveyor (12) shaped in such a way as to engage said electronic components (2), said screw conveyor (12) being designed based on the planar projection of the profile of the electronic components (2),
and **in that** said device comprises one or more guiding elements (19) arranged along the predefined advancement path of the tape (3) and
operatively active on the electronic components (2) so as to limit the deviations due to the engagement with said screw conveyor (12).

2. The feeding device (1) according to claim 1, wherein said means for advancing (11) the tape (3) comprise a motor (13) operatively active on said screw conveyor (12) for rotating it.

3. The feeding device (1) according to claim 2, wherein said motor (13) is a stepper motor which for each complete rotation of the screw conveyor (12) envisages each electronic component (2) advancing by a length which is equivalent to a predefined pitch (p) of the electronic components (2) on the tape (3).

4. The feeding device (1) according to any one of the preceding claims, wherein said means for separating the front electronic component (2a) comprise first means for cutting the unrolled tape (3), said first cutting means being arranged at a first cutting station along the predefined path of the unrolled tape (3).

5. The feeding device (1) according to claim 4, wherein said means for separating the front electronic component (2a) comprise second means for cutting the electrodes of the front electronic component (2a), said second cutting means being arranged at a second cutting station along the predefined path of the tape (3), said second cutting station being placed in sequence after the first cutting station.

6. The feeding device (1) according to claim 5, wherein said control logic comprises a sensor (18) operatively active at said second cutting station to sense the arrival of said front component (2a).

7. The feeding device (1) according to claim 4 or 5, wherein said second cutting means are arranged in such a way as to cut the electrodes of the front component (2a) with an angle that is lower than 45° in such a way that the cut electrodes have a substantially elliptical section.

8. The feeding device (1) according to any one of the preceding claims, wherein said guiding elements (19) define a passage channel (20) for the unrolled tape (3), which is alongside said screw conveyor (12).

## Patentansprüche

1. Vorrichtung zum Zuführen (1) von elektronischen Bauelementen (2), auf einem Band (3) aufgerollt zur Bildung einer Spule (4), umfassend:
Mittel zum Stützen und Abrollen (6) der Spule (4);
Mittel zum Vorschieben (11) des abgerollten Bands (3) entlang eines vorgegebenen Wegs;
eine Steuerungslogik für die Mittel zum Vorschieben (11), umfassend eine elektronische Platine für die elektronische Steuerung der Mittel zum Vorschieben (11) ;
Mittel zum Trennen eines frontseitigen elektronischen Bauelements (2a) von den restlichen elektronischen Bauelementen (2), **dadurch gekennzeichnet, dass** die Mittel zum Vorschieben (11) des Bands (3) einen Schraubenförderer (12) umfassen, der so ausgebildet ist, dass er in Eingriff mit den elektronischen Bauelemente (2) gelangt, wobei der Schraubenförderer (12) basierend auf der Flächenprojektion des Profils der elektronischen Bauelemente (2) ausgestaltet ist und
wobei die Vorrichtung ein oder mehrere Führungselemente (19) umfasst, die entlang des vorgegebenen Vorschubwegs des Bands (3) angeordnet sind und betriebswirksam auf die elektronischen Bauelemente (2) wirken, sodass Abweichungen aufgrund des Eingriffs mit dem Schraubenförderer (12) begrenzt werden.

2. Vorrichtung zum Zuführen (1) nach Anspruch 1, wobei die Mittel zum Vorschieben (11) des Bands (3) einen Motor (13) umfassen, der betriebswirksam auf den Schraubenförderer (12) wirkt, um diesen zu drehen.

3. Vorrichtung zum Zuführen (1) nach Anspruch 2, wobei es sich beim Motor (13) um einen Schrittmotor handelt, der für jede komplette Drehung des Schraubenförderers (12) vorsieht, dass ein jedes elektronisches Bauelement (2) um eine Länge vorgeschoben wird, die einem vorgegebenen Zwischenraum (p) der elektronischen Bauelemente (2) auf dem Band (3) entspricht.

4. Vorrichtung zum Zuführen (1) nach einem der vorhergehenden Ansprüche, wobei die Mittel zum Trennen des frontseitigen elektronischen Bauelements (2a) erste Mittel zum Schneiden des abgerollten Bands (3) umfassen, wobei die ersten Mittel zum Schneiden an einer ersten Schneidestation entlang des vorgegebenen Wegs des abgerollten Bands (3) angeordnet sind.

5. Vorrichtung zum Zuführen (1) nach Anspruch 4, wobei die Mittel zum Trennen des frontseitigen elektronischen Bauelements (2a) zweite Mittel zum Schneiden der Elektroden des frontseitigen Bauelements (2a) umfassen, wobei die zweiten Mittel zum Schneiden an einer zweiten Schneidestation entlang des vorgegebenen Wegs des Bands (3) angeordnet sind, wobei die zweite Schneidestation in Abfolge nach der ersten Schneidestation platziert ist.

6. Vorrichtung zum Zuführen (1) nach Anspruch 5, wobei die Steuerungslogik einen Sensor (18) umfasst, der betriebswirksam an der zweiten Schneidestation wirkt, um die Ankunft des frontseitigen Bauelements (2a) zu erfassen.

7. Vorrichtung zum Zuführen (1) nach Anspruch 4 oder 5, wobei die zweiten Schneidemittel so angeordnet sind, dass sie Elektroden des ersten Bauelements (2a) mit einem Winkel schneiden, der geringer ist als 45°, sodass die geschnittenen Elektroden im Wesentlichen einen elliptischen Querschnitt aufweisen.

8. Vorrichtung zum Zuführen (1) nach einem der vorhergehenden Ansprüche, wobei die Führungselemente (19) einen Durchgangskanal (20) für das abgerollte Band (3) bilden, der sich entlang des Schraubenförderers (12) befindet.

## Revendications

1. Dispositif d'alimentation (1) de composants électroniques (2) disposés sur une bande (3) enroulée pour former une bobine (4), comprenant :
des moyens destinés à supporter et à dérouler (6) la bobine (4) ;
des moyens permettant de faire avancer (11) la bobine déroulée (3) le long d'un parcours prédéfini ;
une logique de commande destinée aux moyens de progression (11) comprenant une carte électronique dédiée à la commande électronique desdits moyens de progression (11); des moyens destinés à séparer un composant électronique antérieur (2a) des composants électroniques restants (2), **caractérisé en ce que** lesdits moyens permettant de faire avancer (11) la bande (3) comprennent un transporteur à vis (12) façonné de telle sorte à se mettre en prise avec lesdits composants électroniques (2), ledit transporteur à vis (12) étant conçu en se basant sur la projection plane du profil des composants électroniques (2), et **en ce que** ledit dispositif comprend un ou plusieurs éléments de guidage (19) disposés le long du parcours de progression prédéfini de la bande (3) et
fonctionnellement actifs sur les composants électroniques (2) de sorte à limiter les déviations dues à la mise en prise avec ledit transporteur à vis (12).

2. Dispositif d'alimentation (1) selon la revendication 1, dans lequel lesdits moyens permettant de faire avancer (11) la bande (3) comprennent un moteur (13) fonctionnellement actif sur ledit transporteur à vis (12) pour le faire tourner.

3. Dispositif d'alimentation (1) selon la revendication 2, dans lequel ledit moteur (13) est un moteur à pas qui pour chaque rotation complète du transporteur à vis (12) prévoit que chaque composant électronique (2) avance d'une longueur étant équivalente à un espacement prédéfini (p) des composants électroniques (2) sur la bande (3).

4. Dispositif d'alimentation (1) selon l'une quelconque des revendications précédentes, dans lequel lesdits moyens destinés à séparer le composant électronique antérieur (2a) comprennent des premiers moyens destinés à couper la bande déroulée (3), lesdits premiers moyens de découpe étant disposés au niveau d'un premier poste de découpe le long du parcours prédéfini de la bande déroulée (3).

5. Dispositif d'alimentation (1) selon la revendication 4, dans lequel lesdits moyens destinés à séparer le composant électronique antérieur (2a) comprennent des seconds moyens destinés à couper les électrodes du composant électronique antérieur (2a), lesdits seconds moyens de découpe étant disposés au niveau d'un second poste de découpe le long du parcours prédéfini de la bande (3), ledit second poste de découpe étant placé en séquence après le premier poste de découpe.

6. Dispositif d'alimentation (1) selon la revendication 5, dans lequel ladite logique de commande comprend un capteur (18) fonctionnellement actif au niveau dudit second poste de découpe pour détecter l'arrivée dudit composant antérieur (2a).

7. Dispositif d'alimentation (1) selon les revendications 4 ou 5, dans lequel lesdits seconds moyens de découpe sont disposés de manière à couper les électrodes du composant antérieur (2a) selon un angle étant inférieur à 45° de manière à ce que les électrodes coupées aient une section substantiellement elliptique.

8. Dispositif d'alimentation (1) selon l'une quelconque des revendications précédentes, dans lequel les éléments de guidage (19) définissent un canal de passage (20) pour la bande déroulée (3) se trouvant le long dudit transporteur à vis (12).
